(19)

Europäisches
Patentamt
European
Patent Office
Office européen
des brevets

(11) **EP 4 636 869 A1**

(12) **EUROPEAN PATENT APPLICATION**
published in accordance with Art. 153(4) EPC

(43) Date of publication:
**22.10.2025 Bulletin 2025/43**

(21) Application number: **24861332.5**

(22) Date of filing: **27.06.2024**

(51) International Patent Classification (IPC):
$H01M\ 4/583^{(2010.01)}$      $H01M\ 4/133^{(2010.01)}$
$H01M\ 4/38^{(2006.01)}$       $C04B\ 35/528^{(2006.01)}$

(52) Cooperative Patent Classification (CPC):
H01M 4/62; C01B 32/05; H01M 4/0428;
H01M 4/0471; H01M 4/133; H01M 4/134;
H01M 4/1395; H01M 4/386; H01M 4/587;
H01M 4/625; H01M 10/0525; H01M 10/4235;
C01P 2002/82; C01P 2004/61; C01P 2004/62;
(Cont.)

(86) International application number:
**PCT/CN2024/102003**

(87) International publication number:
**WO 2025/086695 (01.05.2025 Gazette 2025/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **26.10.2023   CN 202311407790**

(71) Applicant: **BTR NEW MATERIAL GROUP CO.,
LTD.
Shenzhen, Guangdong 518106 (CN)**

(72) Inventors:
• **HE, Peng**
  **Shenzhen, Guangdong 518106 (CN)**
• **LIU, Zhangkun**
  **Shenzhen, Guangdong 518106 (CN)**
• **XIAO, Chengmao**
  **Shenzhen, Guangdong 518106 (CN)**
• **REN, Jianguo**
  **Shenzhen, Guangdong 518106 (CN)**
• **HE, Xueqin**
  **Shenzhen, Guangdong 518106 (CN)**

(74) Representative: **Algemeen Octrooi- en
Merkenbureau B.V.
P.O. Box 645
5600 AP Eindhoven (NL)**

(54) **NEGATIVE ELECTRODE MATERIAL AND PREPARATION METHOD THEREFOR, AND
LITHIUM-ION BATTERY**

(57)    The present disclosure relates to an anode material and a preparation method thereof, and a lithium ion battery. The anode material includes a carbon substrate and an active material, the carbon substrate has pores, and at least a part of the active material is distributed within the pores of the carbon substrate. The carbon dioxide in the pores of the carbon substrate in the anode material of the present disclosure may quickly dissolve in the electrolyte and promote the electrolyte to enter the pores of the anode material. Meanwhile, during the lithium intercalation process, the dissolved carbon dioxide may reduce the decomposition rate of FEC, reduce the formation of loose and irregular SEI, increase the bonding effect between fluorine in the lithium fluoride SEI and lithium in the lithium-silicon alloy, thereby improving the capacity and initial Coulomb efficiency of the anode material.

FIG. 1

**(Cont. next page)**

(52) Cooperative Patent Classification (CPC): (Cont.)
C01P 2006/12; C01P 2006/14; C01P 2006/17;
C01P 2006/40; H01M 2004/021; H01M 2004/027;
Y02E 60/10

**Description**

CROSS REFERENCE TO RELATED APPLICATIONS

The present application claims the benefit of priority of the China application No. 202311407790.0 filed on 26 October 2023 with the title of "ANODE MATERIAL, PREPARATION METHOD THEREOF AND LITHIUM ION BATTERY".

TECHNICAL FIELD

The present application relates to a field of anode material, and particularly, to an anode material, a method for preparing the anode material, and a lithium ion battery.

BACKGROUND

At present, silicon-carbon materials are one of the most advanced anode materials for achieving excellent performance such as high initial Coulomb efficiency, high capacity, long cycle, and low expansion in secondary batteries. The existing silicon-carbon anode materials often have many pores, these pores may adsorb gas molecules from the air, such as oxygen and nitrogen, during the production process. However, the solubility of these gas molecules in aqueous electrolytes is relatively low (0.031 L oxygen/0.024 L nitrogen dissolved in 1L water at 20°C standard atmospheric pressure), so that the electrolyte is blocked by gas molecules and then is difficult to fill into the pores of the anode material, thereby seriously affecting the electrochemical performance of silicon-carbon anode materials.

Carbon dioxide is a greenhouse gas that exists in large quantities. Its emission amounts have been increasing year by year with the process of human industrialization, leading to a rise in global temperatures and posing a serious threat to human survival. Therefore, various countries in the world have implemented a series of measures to reduce carbon dioxide emissions, striving to mitigate or even eliminate the survival crisis caused by the greenhouse effect of carbon dioxide. In the electrochemical reaction process of secondary batteries, the FEC (fluoroethylene carbonate) contained in the electrolyte partially decompose during lithium intercalation process, producing $CO_2$ and solid decomposition products (such as types of LiF, -CHF-$OCO_2$ compounds, etc.), forming LiF dominated SEI and "adhesion effect". Therefore, the generation of $CO_2$ is beneficial to the absorption of electrolyte by anode materials. However, the initial generation of $CO_2$ often occurs at a fast rate, which leads to the formation of loose and irregular SEI and even cracks, thereby affecting the initial Coulomb efficiency and capacity of silicon-carbon anode materials.

SUMMARY

The purpose of the present disclosure is to provide an anode material and a preparation method thereof, and a lithium ion battery. The carbon dioxide in the pores of the carbon substrate in the anode material of the present disclosure may quickly dissolve in the electrolyte and promote the electrolyte to enter the pores of the anode material. Meanwhile, during the lithium intercalation process, the dissolved carbon dioxide may reduce the decomposition rate of fluoroethylene carbonate (FEC), reduce the formation of loose and irregular SEI, increase the bonding effect between fluorine in the lithium fluoride SEI and lithium in the lithium-silicon alloy, thereby improving the capacity and initial Coulomb efficiency of the anode material.

In a first aspect, the present disclosure provides an anode material including a carbon substrate and an active material, the carbon substrate has pores, and the active material is distributed within the pores of the carbon substrate;

in the infrared spectrum of the anode material, there are a peak with a first absorption peak having a peak located at $2375 \pm 1 cm^{-1}$, denoted as $A_1$, and a valley located at $2394 \pm 1 cm^{-1}$, denoted as $A_0$; and a second absorption peak at $2919 \pm 1 cm^{-1}$, denoted as $B_1$; and a valley located at $2821 \pm 1 cm^{-1}$, denoted as $B_0$;
the anode material has a carbon dioxide adsorption index P, wherein

$$P = (A_1 - A_0)/ (B_1 - B_0), \text{ and } 0.25 \leq P \leq 0.70.$$

In some embodiments, the carbon substrate includes porous carbon.
In some embodiments, the active material includes nano-silicon.
In some embodiments, the active material includes nano-silicon, and the nano-silicon includes crystalline silicon and/or amorphous silicon.
In some embodiments, the carbon substrate has an average particle size ranging from 8 $\mu$m to 15 $\mu$m.
In some embodiments, a mass content of the carbon element in the anode material ranges from 49% to 51%.
In some embodiments, a mass content of active material in the anode material ranges from 45% to 50%.
In some embodiments, the anode material contains oxygen element, and a mass content of the oxygen element in the anode material ranges from 1.0% to 4%.

In some embodiments, the anode material has an average particle size ranges from 0.8 $\mu$m to 25 $\mu$m.

In some embodiments, the anode material has a specific surface area ranging from 1 m$^2$/g to 300 m$^2$/g.

In some embodiments, the anode material has pores, and the pores in the anode material include micro-pores, meso-pores and macro-pores.

In some embodiments, the pores in the anode material have an average pore size ranging from 1nm to 10 nm.

In some embodiments, a total pore volume of the anode material ranged from 0.001 cm$^3$/g to 0.20 cm$^3$/g.

In some embodiments, the anode material has pores, the pores in the anode material include micro-pores, and a pore volume of the micro-pore has a volume proportion of 30% to 65% of a total pore volume of all pores.

In some embodiments, the anode material has pores, the pores in the anode material include meso-pores, and a pore volume of the meso-pore has a volume proportion of 35% to 70% of a total pore volume of all pores.

In some embodiments, the anode material has pores, the pores in the anode material include macro-pores, and a pore volume of the macro-pore has a volume proportion of 0% to 5% of a total pore volume of all pores.

In a second aspect, the present disclosure provides a method for preparing an anode material. The method includes following steps:

- providing a metal catalytic matrix, and introducing a carbon source gas to perform carbon deposition on the metal catalytic matrix to obtain a carbon substrate, the carbon substrate has pores; and
- introducing a reaction gas containing an active material, and performing vapor deposition on the carbon substrate to obtain the anode material.

In some embodiments, before introducing a carbon source gas to perform carbon deposition on the metal catalytic matrix, the method further includes: placing the metal catalytic matrix in an inert gas to perform air discharging treatment.

In some embodiments, a metal in the metal catalytic matrix includes at least one of iron, nickel, copper, gold, or an alloy.

In some embodiments, a metal in the metal catalytic matrix includes an alloy, and the alloy includes at least one of an iron-cobalt alloy, a nickel-copper alloy, and an iron-nickel-copper alloy.

In some embodiments, the inert gas includes at least one of nitrogen, argon, and helium.

In some embodiments, the inert gas has a flow rate ranging from 20 ccm to 200 sccm.

In some embodiments, the inert gas has an introduction time ranging from 0.5 h to 3 h.

In some embodiments, after introducing a reaction gas containing an active material and performing vapor deposition on the carbon substrate, the method further includes: introducing sequentially and repeatedly the carbon source gas and the reaction gas containing the active material for carbon deposition and vapor deposition for 4 h to 24 h.

In some embodiments, the carbon source gas includes at least one of methane, acetylene, ethane, and propane.

In some embodiments, the carbon source gas has a flow rate ranging from 10 sccm to 80 sccm.

In some embodiments, the carbon source gas has an introduction time ranging from 5 min to 30 min.

In some embodiments, the reaction gas containing the active material includes a silicon source gas.

In some embodiments, the reaction gas containing the active material includes a silicon source gas, and the silicon source gas includes silane and/or disilane.

In some embodiments, the reaction gas containing the active material includes a silicon source gas, and the silicon source gas has a flow rate of 10 sccm to 80 sccm.

In some embodiments, the reaction gas containing the active material includes a silicon source gas, and the silicon source gas has an introduction time ranging from 5 min to 30 min.

In some embodiments, a temperature of the carbon deposition and the vapor deposition ranges from 600°C to 700°C.

In some embodiments, a heating rate of the carbon deposition and the vapor deposition ranges from 1°C/min to 12°C/min.

In some embodiments, the carbon deposition and the vapor deposition are performed in an inert gas.

In some embodiments, the carbon deposition and the vapor deposition are performed in the inert gas, and the inert gas includes at least one of nitrogen, argon, and helium.

In some embodiments, the carbon deposition and the vapor deposition are performed in the inert gas, and a flow rate of the inert gas ranges from 5 sccm to 50 sccm.

In some embodiments, the method further includes separating the metal catalytic matrix from a deposition product, and then sequentially performing mechanical pulverization and airflow pulverization on the deposition product.

In some embodiments, the mechanical pulverization has a time ranging from 0.5 h to 3 h.

In some embodiments, the airflow pulverization has a time ranging from 0.5 h to 3 h.

In a third aspect, the present disclosure provides a lithium ion battery, the lithium ion battery includes the anode material according to the first aspect or the anode material prepared by the method according to the second aspect.

Compared with the prior art, the technical solution of the present disclosure has at least following beneficial effects:

The anode materials provided by the present disclosure include a carbon substrate and an active material. The carbon substrate has pores, and the active material is distributed within the pores of the carbon substrate, allowing the anode material to maintain a high capacity; the carbon substrate may provide a certain volume space for the expansion of the active material, which is conducive to maintaining the structural stability of the anode material. The carbon substrate may also provide electron and ion transport pathways, improve lithium ion transport efficiency, and thus improving the initial Coulomb efficiency of the anode material. Meanwhile, the pores of the carbon substrate contain carbon dioxide gas, which may quickly dissolve in the electrolyte and promote the electrolyte to enter the pores of the anode material. During the lithium intercalation process, the dissolved carbon dioxide gas may reduce the decomposition rate of fluoroethylene carbonate (FEC) in the electrolyte, reduce the formation of loose and irregular solid electrolyte interphase (SEI) on the surface of the anode material, increase the bonding effect between fluorine in the lithium fluoride SEI and lithium in the lithium silicon alloy, improve the interface stability of the lithium fluoride SEI, reduce the occurrence of side reactions, reduce the consumption of active lithium ions, and thus improving the capacity and initial Coulomb efficiency of the anode material.

The present disclosure provides a preparation method of an anode material, firstly, the carbon source gas is deposited on the metal catalytic matrix to obtain a carbon substrate, the carbon substrate has pores, and the reaction gas containing the active material is introduced and vapor deposition is performed on the carbon substrate, in the processes of carbon deposition and vapor deposition, the metal catalytic matrix may improve deposition efficiency, accelerate the formation of the carbon substrate and the deposition of the active material, the active material may be fully filled into the pores of the carbon substrate, enable the prepared anode material to maintain a high capacity by vapor deposition; Meanwhile, the carbon substrate may provide a certain volume space for the expansion of the active material, which is conducive to maintaining the structural stability of the anode material, the carbon substrate may also provide electron and ion transport pathways, improve the lithium ion transport efficiency, and thus improving the initial Coulomb efficiency of the anode material. In addition, the pores of the carbon substrate may adsorb carbon dioxide gas. The carbon dioxide gas adsorbed in the pores of the carbon substrate may quickly dissolve in the electrolyte and promote the electrolyte to enter the pores of the anode material. Meanwhile, during the lithium intercalation process, the dissolved carbon dioxide gas may reduce the decomposition rate of fluoroethylene carbonate (FEC) in the electrolyte, reduce the formation of a loose and irregular solid electrolyte interphase (SEI) on the surface of the anode material, increase the bonding effect between fluorine in the lithium fluoride SEI and lithium in the lithium silicon alloy, improve the interface stability of the lithium fluoride SEI, reduce the occurrence of side reactions, reduce the consumption of active lithium ions, and thus improving the capacity and initial Coulomb efficiency of the anode material.

## BRIEF DESCRIPTION OF DRAWINGS

Following further describes the present disclosure with reference to the accompanying drawings and embodiments.

FIG. 1 is a structural schematic diagram of an anode material according to an embodiment of the present disclosure;
FIG. 2 is an infrared spectrogram of the anode material prepared in Example 1 to Example 4 of the present disclosure;
FIG. 3 is an infrared spectrogram of the anode material prepared in Example 1 and Comparative Examples 1 to 4 of the present disclosure; and
FIG. 4 is an infrared spectrogram of the anode material prepared in Example 1 and Comparative Examples 5 to 8 of the present disclosure.

## DESCRIPTION OF EMBODIMENTS

In order to better illustrate the technical solutions of the present disclosure, detailed description of embodiments of the present disclosure will be provided below in conjunction with the accompanying drawings.

It is to be made clear that the described embodiments are only some rather than all of the embodiments of the present disclosure. All other embodiments obtained by those of ordinary skill in the art based on the embodiments in the present disclosure without creative efforts fall within the protection scope of the present disclosure.

The terms used in the embodiments of the present disclosure are merely for the purpose of describing particular embodiments but not intended to limit the present disclosure. The singular forms of "a", "an" and "the" used in the embodiments of the present disclosure and the appended claims are also intended to include plural forms, unless clearly indicating others.

It should be understood that the term "and/or" used herein is merely an association relationship describing an associated object, and indicates that there may be three relationships, for example, A and/or B, and may indicate: A alone, both A and B, and B alone. In addition, the character "/" herein generally means an "or" relationship between the associated objects.

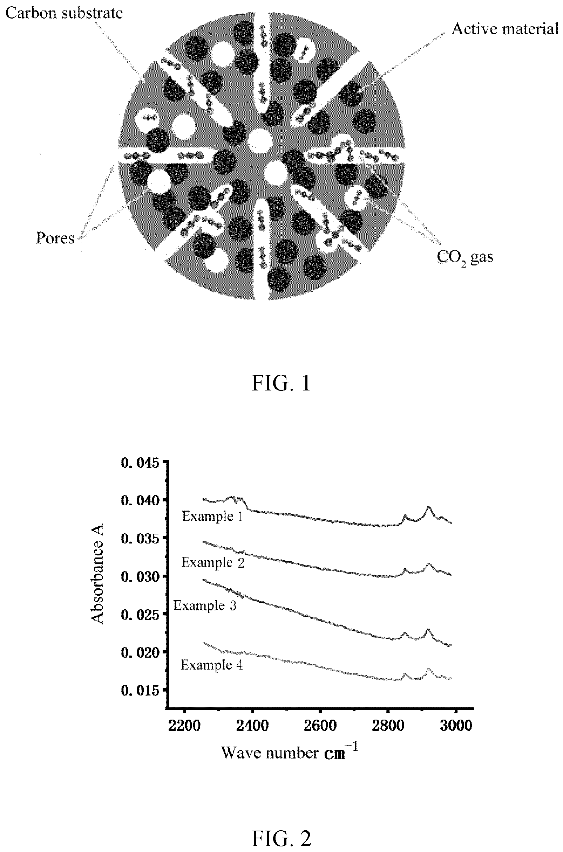

In a first aspect, as shown in FIG.1, the present disclosure provides an anode material including a carbon substrate and an active material, the carbon substrate has pores, and the active material is distributed within the pores of the carbon substrate;

in the infrared spectrum of the anode material, there are a first absorption peak having a peak located at 2375 $\pm$1cm-1, denoted as $A_1$, and a valley located at 2394$\pm$1cm-1, denoted as $A_0$; and a second absorption peak having a peak located at 2919$\pm$1cm-1, denoted as $B_1$; and a valley located at 2821$\pm$1cm-1, denoted as $B_0$; and the anode material has a carbon dioxide adsorption index P, wherein P = $(A_1 - A_0)/ (B_1 - B_0)$, and $0.25 \leq P \leq 0.70$.

The anode materials provided by the present disclosure include a carbon substrate and an active material. The carbon substrate has pores, and the active material is distributed within the pores of the carbon substrate, allowing the anode material to maintain a high capacity; the carbon substrate may provide a certain volume space for the expansion of the active material, which is conducive to maintaining the structural stability of the anode material. The carbon substrate may also provide electron and ion transport pathways, improve lithium ion transport efficiency, and thus improving the initial Coulomb efficiency of the anode material. Meanwhile, the pores of the carbon substrate contain carbon dioxide gas, which may quickly dissolve in the electrolyte and promote the electrolyte to enter the pores of the anode material. During the lithium intercalation process, the dissolved carbon dioxide gas may reduce the decomposition rate of fluoroethylene carbonate (FEC) in the electrolyte, reduce the formation of loose and irregular solid electrolyte interphase (SEI) on the surface of the anode material, increase the bonding effect between fluorine in the lithium fluoride SEI and lithium in the lithium silicon alloy, improve the interface stability of the lithium fluoride SEI, reduce the occurrence of side reactions, reduce the consumption of active lithium ions, and thus improving the capacity and initial Coulomb efficiency of the anode material.

Specifically, the value of P may be 0.25, 0.26, 0.28, 0.30, 0.33, 0.35, 0.37, 0.40, 0.45, 0.50, 0.56, 0.60, 0.63, 0.66, 0.69, or 0.70, which is not limited here.

It may be understood that the P value may represent the ability of the anode material to adsorb $CO_2$. The larger the P value, the stronger the ability of the anode material to adsorb $CO_2$, and the more $CO_2$ is adsorbed in the anode material. Meanwhile, the ability of the anode material to adsorb $CO_2$ is related to the proportion of micro-pores in the anode material. The more micro-pores there are, the stronger the ability of the anode material to adsorb $CO_2$.

When the P value is too high, it indicates that there is more $CO_2$ adsorbed in the anode material, but Meanwhile, it also indicates that there are more micro-pores in the anode material, that is, the micro-pores inside the anode material particles are less filled with silicon, and the silicon content in the anode material is low, resulting in a lower capacity of the anode material. When the P value is too small, it indicates that there is less $CO_2$ adsorbed in the anode material, and it also indicates that there are fewer micro-pores in the anode material, that is, the micro-pores inside the anode material particles are filled with more silicon, resulting in a higher silicon content in the anode material and an increase in its capacity; however, an increase in silicon content in the anode material will lead to a decrease in the conductivity of the material particles, which in turn will result in a decrease in the initial Coulomb efficiency of the anode material.

It should be noted that the values of $A_1$ to $A_0$ represent the relative absorbance of carbon dioxide, while the values of $B_1$ to $B_0$ represent the relative absorbance of $-CH_2$ (carbon substrate).

In some embodiments, the carbon substrate includes porous carbon.

In some embodiments, the active material includes nano-silicon, and the nano-silicon includes crystalline silicon and/or amorphous silicon.

In some embodiments, the carbon substrate has an average particle size ranging from 8 $\mu$m to 15 $\mu$m, which may specifically be 8 $\mu$m, 9 $\mu$m, 10 $\mu$m, 11 $\mu$m, 12 $\mu$m, 13 $\mu$m, 14 $\mu$m, or 15 $\mu$m, etc., but it is not limited to the listed values. Other values not listed within this range are also applicable.

In some embodiments, a mass content of the carbon element in the anode material ranges from 49% to 51%, which may specifically be 49%, 49.3%, 49.5%, 49.6%, 49.7%, 50%, 50.2%, 50.6%, 50.7%, 50.9% or 51%, etc., and certainly may also be other values within the above range, which is not limited herein.

In some embodiments, a mass content of the active material in the anode material ranges from 45% to 50%, which may specifically be 45%, 45.6%, 46%, 46.8%, 47.2%, 47.9%, 48%, 48.3%, 49%, 49.3% or 50% etc., and certainly may also be other values within the above range, which is not limited herein. It may be understood that controlling the mass content of the active material within the above range may effectively control the volume expansion of the anode material and the capacity of the anode material at the same time; meanwhile, since the active material preferentially occupies micro-pores in the preparation process of the anode material, the mass content of the active material is controlled within the above range, which may ensure that a certain number of micro-pores are reserved in the anode material particles, which is beneficial to the adsorption of carbon dioxide gas by the anode material.

In some embodiments, the anode material contains oxygen element, and a mass content of the oxygen element in the anode material ranges from 1.0% to 4.0%, which may specifically be 1.0%, 1.2%, 1.3%, 1.5%, 2%, 2.1%, 2.3%, 2.5%, 3%, 3.2%, 3.5%, 4%, etc., and certainly may also be other values within the above range, which is not limited herein. In the present disclosure, controlling the mass content of oxygen element in the anode material within the above range is beneficial to improving the specific capacity of the anode material and reducing the formation of inactive silica.

In some embodiments, the anode material has an average particle size ranging from 0.8 $\mu$m to 25 $\mu$m, which may specifically be 0.8 $\mu$m, 1 $\mu$m, 2 $\mu$m, 3 $\mu$m, 3.5 $\mu$m, 4 $\mu$m, 8 $\mu$m, 10 $\mu$m, 15 $\mu$m, 20 $\mu$m, 21 $\mu$m, 23 $\mu$m, 24 $\mu$m or 25 $\mu$m, etc., and certainly may also be other values within the above range, which is not limited herein. In the present disclosure, the average particle size of the anode material is controlled within the above range, which is beneficial to improving the cycling performance of the lithium ion battery made of the anode material.

In some embodiments, the anode material has pores, and the pores in the anode material include micro-pores, meso-pores and macro-pores.

In some embodiments, the pores of the anode material has an average pore size ranging from 1nm to 10 nm, which may specifically be 1 nm, 2 nm, 3 nm, 4 nm, 5 nm, 6 nm, 7 nm, 8 nm, 9 nm or 10 nm, etc., and certainly may also be other values within the above range, which is not limited herein. Controlling the average pore size of the anode material within the above range is beneficial to the adsorption of $CO_2$ by the anode material.

In some embodiments, the total pore volume of the anode material is 0.001cm$^3$/g to 0.20 cm$^3$/g, which may specifically be 0.001 cm$^3$/g, 0.005 cm$^3$/g, 0.01 cm$^3$/g, 0.02 cm$^3$/g, 0.05 cm$^3$/g, 0.08 cm$^3$/g, 0.12 cm$^3$/g, 0.15 cm$^3$/g, 0.18 cm$^3$/g or 0.20 cm$^3$/g etc., which is not limited here.

In some embodiments, the anode material has pores, the pores in the anode material include micro-pores, and a pore volume of the micro-pore has a volume proportion of 30% to 65%, which may specifically be 30%, 35%, 40%, 50%, 55%, 58%, 60%, 62%, 63%, or 65% of a total pore volume of all pores, but is not limited to the recited values, and other unlisted values within this range are also applicable.

In some embodiments, the anode material has pores, and the pores in the anode material include meso-pores, and a pore volume of the meso-pore has a volume proportion of 35% to 70%, which may specifically be 35%, 36%, 37%, 38%, 40%, 45%, 50%, 55%, 60%, 65%, or 70%, etc. of a total pore volume of all pores, and certainly may also be other values within the above range, which is not limited herein.

In some embodiments, the anode material has pores, and the pores in the anode material include macro-pore, and a pore volume of the macro-pore has a volume proportion of 0% to 5%, which may specifically be 0%, 0.5%, 0.8%, 1%, 1.5%, 2.1%, 3.2%, 3.8%, 4.4%, 4.7% or 5%, etc. of a total pore volume of all pores, and certainly may also be other values within the above range, which is not limited herein.

In some embodiments, the specific surface area of the pores of the anode material is 1 m$^2$/g to 300 m$^2$/g, which may specifically be 1 m$^2$/g, 5 m$^2$/g, 10 m$^2$/g, 20 m$^2$/g, 50 m$^2$/g, 100 m$^2$/g, 125 m$^2$/g, 130 m$^2$/g, 150 m$^2$/g, 200 m$^2$/g, 250 m$^2$/g, 300 m$^2$/g, etc., and certainly may also be other values within the above range, which is not limited herein. Controlling the specific surface area of the anode material within the above range is beneficial to improving the cycling performance of the lithium ion battery made by the anode material.

In a second aspect, the present disclosure provides a method for preparing an anode material. The method includes following steps:

Step S100, a metal catalytic matrix is provided, and a carbon source gas is introduced to perform carbon deposition on the metal catalytic matrix to obtain a carbon substrate, the carbon substrate having pores.

Step S200, a reaction gas containing an active material is introduced, and vapor deposition is performed on the carbon substrate to obtain an anode material.

The present disclosure provides a preparation method of an anode material, firstly, the carbon source gas is deposited on the metal catalytic matrix to obtain a carbon substrate, the carbon substrate has pores, and the reaction gas containing the active material is introduced and vapor deposition is performed on the carbon substrate, in the processes of carbon deposition and vapor deposition, the metal catalytic matrix may improve deposition efficiency, accelerate the formation of the carbon substrate and the deposition of the active material, the active material may be fully filled into the pores of the carbon substrate, enable the prepared anode material to maintain a high capacity by vapor deposition; Meanwhile, the carbon substrate may provide a certain volume space for the expansion of the active material, which is conducive to maintaining the structural stability of the anode material, the carbon substrate may also provide electron and ion transport pathways, improve the lithium ion transport efficiency, and thus improving the initial Coulomb efficiency of the anode material. In addition, the pores of the carbon substrate may adsorb carbon dioxide gas. The carbon dioxide gas adsorbed in the pores of the carbon substrate may quickly dissolve in the electrolyte and promote the electrolyte to enter the pores of the anode material. Meanwhile, during the lithium intercalation process, the dissolved carbon dioxide gas may reduce the decomposition rate of fluoroethylene carbonate (FEC) in the electrolyte, reduce the formation of a loose and irregular solid electrolyte interphase (SEI) on the surface of the anode material, increase the bonding effect between fluorine in the lithium fluoride SEI and lithium in the lithium silicon alloy, improve the interface stability of the lithium fluoride SEI, reduce the occurrence of side reactions, reduce the consumption of active lithium ions, and thus improving the capacity and initial Coulomb efficiency of the anode material.

Step S100, a metal catalytic matrix is provided, and a carbon source gas is introduced to perform carbon deposition on the metal catalytic matrix to obtain a carbon substrate, the carbon substrate has pores.

In some embodiments, before introducing a carbon source gas to perform carbon deposition on the metal catalytic matrix, the method further includes: placing the metal catalytic matrix in an inert gas to perform air discharging treatment.

In some embodiments, a metal in the metal catalytic matrix includes at least one of iron, nickel, copper, gold, or an alloy.

In some embodiments, a metal in the metal catalytic matrix includes an alloy, the alloy includes at least one of an iron-cobalt alloy, a nickel-copper alloy, and an iron-nickel-copper alloy.

In some embodiments, the inert gas includes at least one of nitrogen, argon, and helium.

In some embodiments, the inert gas has a flow rate ranging from 20 sccm to 200 sccm, which may specifically be 20 sccm, 30 sccm, 50 sccm, 80 sccm, 100 sccm, 120 sccm, 150 sccm, 180 sccm or 200 sccm, etc., and certainly may also be other values within the above range, which is not limited herein.

In some embodiments, the inert gas has an introduction time ranging from 0.5 h to 3 h, which may specifically be 0.5 h, 0.8 h, 1 h, 1.5 h, 1.8 h, 2 h, 2.3 h, 2.5 h or 3 h, etc., and certainly may also be other values within the above range, which is not limited herein.

In some embodiments, the carbon source gas includes at least one of methane, acetylene, ethane, and propane.

In some embodiments, the carbon source gas has a flow rate ranging from 10 sccm to 80 sccm, which may specifically be 10 sccm, 20 sccm, 30 sccm, 40 sccm, 50 sccm, 60 sccm, 70 sccm or 80 sccm, etc., and certainly may also be other values within the above range, which is not limited herein.

In some embodiments, the carbon source gas has a introduction time ranging from 5 min to 30 min, which may specifically be 5 min, 8 min, 10 min, 15 min, 20 min, 22 min, 25 min, 28 min or 30 min, etc., and certainly may also be other values within the above range, which is not limited herein.

Step S200, a reaction gas containing an active material is introduced, and vapor deposition is performed on the carbon substrate to obtain an anode material.

In some embodiments, the reaction gas containing the active material includes a silicon source gas.

In some embodiments, the reaction gas containing the active material includes the silicon source gas, the silicon source gas includes silane and/or disilane.

In some embodiments, the reaction gas containing the active material includes a silicon source gas, and the silicon source gas has a flow rate ranging from 10 sccm to 80 sccm, which may specifically be 10 ccm, 20 ccm, 30 sccm, 40 sccm, 50 sccm, 60 sccm, 70 sccm or 80 sccm, etc., and certainly may also be other values within the above range, which is not limited herein.

In some embodiments, the reaction gas containing the active material includes a silicon source gas, and the silicon source gas has a introduction time ranging from 5 min to 30 min, which may specifically be 5 min, 8 min, 10 min, 15 min, 20 min, 22 min, 25 min, 28 min or 30 min, etc., and certainly may also be other values within the above range, which is not limited herein.

In some embodiments, the carbon deposition and the sillicon deposition has a temperature ranging from 600°C to 700°C, which may specifically be 600°C, 620°C, 650°C, 660°C, 680°C, 690°C or 700°C, which is not limited herein.

In some embodiments, the heating rate of carbon deposition and vapor deposition is between 1°C/min and 12°C/min, which may specifically be 1°C/min, 2°C/min, 5°C/min, 8°C/min, 9°C/min, 10°C/min, 11°C/min, or 12°C/min, etc., and certainly may also be other values within the above range, which is not limited herein.

In some embodiments, the carbon deposition and the vapor deposition are performed in an inert gas.

In some embodiments, the carbon deposition and the vapor deposition are performed in the inert gas, the inert gas includes at least one of nitrogen, argon, and helium.

In some embodiments, the carbon deposition and the vapor deposition are performed in an inert gas, and the inert gas has a flow rate ranging from 5 sccm to 50 sccm, which may specifically be 5 sccm, 10 sccm, 15 sccm, 20 sccm, 25 sccm, 30 sccm, 40 sccm, 50 sccm, etc., and certainly may also be other values within the above range, which is not limited herein.

In some embodiments, after introducing the reaction gas containing the active material and performing vapor deposition on the carbon substrate, the method further includes: repeatedly introducing carbon source gas and reaction gas containing the active material for carbon deposition and vapor deposition for 4 h to 24 h, which may specifically be 4 h, 8 h, 10 h, 15 h, 18 h, 20 h, 22 h, or 25 h, etc., and certainly may also be other values within the above range, which is not limited herein.

In the present disclosure, repeated vapor deposition and carbon deposition may improve the deposition uniformity of the active material, enhance production efficiency, and reduce thermal energy waste during the preparation process.

In some embodiments, the method further includes separating the metal catalytic matrix from a deposition product, and then sequentially performing mechanical pulverization and airflow pulverization on the deposition product.

In some embodiments, the mechanical pulverization has a time ranging from 0.5 h to 3 h, which may specifically be 0.5 h, 0.8 h, 1 h, 1.5 h, 1.8 h, 2 h, 2.4 h, 2.6 h or 3 h, etc., and certainly may also be other values within the above range, which is not limited herein.

In some embodiments, the airflow pulverization has a time ranging from 0.5 h to 3 h, which may specifically be 0.5 h, 0.8 h, 1 h, 1.5 h, 1.8 h, 2 h, 2.4 h, 2.6 h or 3 h, etc., and certainly may also be other values within the above range, which is not limited herein.

In a third aspect, the present disclosure provides a lithium ion battery, the lithium ion battery includes the anode material according to the first aspect or the anode material prepared by the preparation method according to the second aspect.

Examples

Example 1

(1) The iron metal catalytic plate was placed in a tube furnace, argon gas was introduced at a flow rate of 100 sccm for 0.5 hours to remove air from the tube furnace, then the flow rate of argon gas was adjusted to 10 sccm and the tube furnace was heated at a rate of 10°C/min; after the tube furnace was heated to 650°C, acetylene gas was introduced at a flow rate of 50 sccm for 20 minutes to perform carbon deposition on an iron metal catalytic plate, and then the acetylene gas was shut off to obtain a carbon substrate.
(2) Then, silane gas was introduced at a flow rate of 30 sccm for 20 minutes to perform vapor deposition on the carbon substrate, and then the silane gas was shut off.
(3) The steps (1) and (2) was repeated in sequence for 8h, the iron metal catalytic plate was taken out after cooled to room temperature, the deposited product was separated from the iron metal catalytic plate, and the separated silicon-carbon material was sequentially subjected to mechanical pulverization and airflow pulverization for 1h to obtain an anode material.

The anode material prepared in this Example includes a carbon substrate and an active material, the carbon substrate has pores, the active material is distributed in the pores of the carbon substrate, and the active material includes nano-silicon.

Example 2

(1) The iron-nickel alloy metal catalytic plate was placed in a tube furnace, argon gas was introduced at a flow rate of 100 sccm for 0.5 hours to remove air from the tube furnace, then the flow rate of argon gas was adjusted to 10 sccm and the tube furnace was heated at a rate of 10°C/min; after the tube furnace was heated to 650°C, acetylene gas was introduced at a flow rate of 50 sccm for 20 minutes to perform carbon deposition on the iron-nickel alloy metal catalytic plate, and then the acetylene gas was shut off to obtain the carbon substrate.
(2) Then, silane gas was introduced at a flow rate of 35 sccm for 20 minutes to perform vapor deposition on the carbon substrate, and then the silane gas was shut off.
(3) The steps (1) and (2) was repeated in sequence for 8h, the iron-nickel alloy metal catalytic plate was taken out after cooled to room temperature, the deposited product was separated from the iron-nickel alloy metal catalytic plate, and the separated silicon-carbon material was sequentially subjected to mechanical pulverization and airflow pulverization for 1h to obtain the anode material.

The anode material prepared in this Example includes a carbon substrate and an active material, the carbon substrate has pores, the active material is distributed in the pores of the carbon substrate, and the active material includes nano-silicon.

Example 3

(1) The nickel metal catalytic plate was placed in a tube furnace, argon gas was introduced at a flow rate of 200 sccm for 0.5 hours to remove air from the tube furnace, then the flow rate of argon gas was adjusted to 10 sccm and the tube furnace was heated at a rate of 10°C/min; after the tube furnace was heated to 650°C, acetylene gas was introduced at a flow rate of 50 sccm for 20 minutes to perform carbon deposition on the nickel metal catalytic plate, and then the acetylene gas was shut off to obtain the carbon substrate.

(2) Then, silane gas was introduced at a flow rate of 40 sccm for 20 minutes to perform vapor deposition on the carbon substrate, and then the silane gas was shut off.

(3) The steps (1) and (2) was repeated in sequence for 8 h, the nickel metal catalytic plate was taken out after cooled to room temperature, the deposited product was separated from the nickel metal catalytic plate, and the separated silicon-carbon material was sequentially subjected to mechanical pulverization and airflow pulverization for 1h to obtain the anode material.

The anode material prepared in this Example includes a carbon substrate and an active material, the carbon substrate has pores, the active material is distributed in the pores of the carbon substrate, and the active material includes nano-silicon.

Example 4

(1) The copper metal catalytic plate was placed in a tube furnace, argon gas was introduced at a flow rate of 200 sccm for 0.5 hours to remove air from the tube furnace, then the flow rate of argon gas was adjusted to 10 sccm and the tube furnace was heated at a rate of 10°C/min; after the tube furnace was heated to 650°C, acetylene gas was introduced at a flow rate of 50 sccm for 20 minutes to perform carbon deposition on the copper metal catalytic plate, and then the acetylene gas was shut off to obtain the carbon substrate.

(2) Then, silane gas was introduced at a flow rate of 45 sccm for 20 minutes to perform vapor deposition on the carbon substrate, and then the silane gas was shut off.

(3) The steps (1) and (2) was repeated in sequence for 8h, the copper metal catalytic plate was taken out after cooled to room temperature, the deposited product was separated from the copper metal catalytic plate, and the separated silicon-carbon material was sequentially subjected to mechanical pulverization and airflow pulverization for 1h to obtain the anode material.

The anode material prepared in this Example includes a carbon substrate and an active material, the carbon substrate has pores, the active material is distributed in the pores of the carbon substrate, and the active material includes nano-silicon.

Example 5

Different from Example 1, in (2), then silane gas was introduced at a flow rate of 10 sccm for 30 min to perform vapor deposition on the carbon substrate, and then the silane gas was shut off.

The anode material prepared in this Example includes a carbon substrate and an active material, the carbon substrate has pores, the active material is distributed in the pores of the carbon substrate, and the active material includes nano-silicon.

Example 6

Different from Example 1, in (2), then silane gas was introduced at a flow rate of 80 sccm for 5 min to perform vapor deposition on the carbon substrate, and then the silane gas was shut off. The anode material prepared in this Example includes a carbon substrate and an active material, the carbon substrate has pores, the active material is distributed in the pores of the carbon substrate, and the active material includes nano-silicon.

Comparative Example 1

The anode material prepared in Example 1 was subjected to a multi-fluoropolymer plugging-pore experiment, and the specific steps were as follows.

(1) 30g of the anode material prepared in Example 1, 1g acrylic acid, 2g polypropylene pyrrolidone and 300 mL n-butanol were placed in a reaction flask, and nitrogen was introduced after vacuumizing to ensure that the reaction environment was a nitrogen environment.

(2) The reaction flask was placed in a magnetic stirring water bath, stirred and heated to 65°C, then 1g azodiisobutyronitrile and 20 mL cyclopentane were added and kept at constant temperature for 0.5 h, then 1g hexafluorobutyl acrylate and 20 mL acetone were added and kept at constant temperature for 0.5 h, then the reaction solution was heated to 70°C and kept at constant temperature for 6h to end the reaction, and finally, subjected to suction filtration and ethanol washing to obtain the comparative anode material 1 with pores plugged by fluoropolymer.

### Comparative Example 2

Different from Comparative Example 1, (2) the reaction flask was placed in a magnetic stirring water bath, stirred and heated to 65°C, then 1g azodiisobutyronitrile and 20 mL cyclopentane were added and kept at constant temperature for 0.5 h, then 2 g hexafluorobutyl acrylate and 20 mL acetone were added and kept at constant temperature for 0.5 h, then the reaction solution was heated to 70°C and kept at constant temperature for 6 h to end the reaction, and finally, subjected to suction filtration and ethanol washing to obtain the comparative anode material 2 with pores plugged by fluoropolymer.

### Comparative Example 3

Different from Comparative Example 1, (2) the reaction flask was placed in a magnetic stirring water bath, stirred and heated to 65°C, then 2g azodiisobutyronitrile and 20 mL cyclopentane were added and kept at constant temperature for 0.5 h, then 2g hexafluorobutyl acrylate and 20 mL acetone were added and kept at constant temperature for 0.5 h, then the reaction solution was heated to 70°C and kept at constant temperature for 6 h to end the reaction, and finally, subjected to suction filtration and ethanol washing to obtain the comparative anode material 3 with pores plugged by fluoropolymer.

### Comparative Example 4

A silicon-free porous carbon preparation experiment was performed on the silicon-carbon anode active material prepared in Example 1, the specific steps are as follows:
30 g of the anode material prepared in Example 1 was placed in 250 mL of a hydrofluoric acid solution with a mass fraction of 20%, soaked for 12 h, and then subjected to suction filtration and pure water washing to obtain a comparative porous carbon anode active material 4.

### Comparative Example 5

A carbon growth plugging-pore experiment was performed on the silicon-carbon anode active material prepared in Example 1, the specific steps are as follows:

(1) 30 g of the anode material prepared in Example 1 was placed into a tube furnace and argon was introduced at a flow rate of 100 sccm for 0.5 h to remove air. Then the flow rate of argon was adjusted to 10 sccm, and the tube furnace was heated at a heating rate of 10°C/min to 650°C.
(2) Then acetylene gas was introduced at a flow rate of 10 sccm for 10 min, the acetylene gas was shut off, and the temperature was naturally reduced to room temperature to obtain a comparative anode material 5.

### Comparative Example 6

Different from Comparative Example 5, (2) then acetylene gas was introduced at a flow rate of 10 sccm for 20 min, the acetylene gas was shut off, and the temperature was naturally reduced to room temperature to obtain a comparative anode material 6.

### Comparative Example 7

Different from Comparative Example 5, (2) then acetylene gas was introduced at a flow rate of 10 sccm for 30 min, the acetylene gas was shut off, and the temperature was naturally reduced to room temperature to obtain a comparative anode material 7.

### Comparative Example 8

Different from Comparative Example 5, (2) then acetylene gas was introduced at a flow rate of 10 sccm for 40 min, the acetylene gas was shut off, and the temperature was naturally reduced to room temperature to obtain a comparative anode material 8.

Test Method

(1) Test Method for Mass Content of Carbon in Anode Material

German Bruker/German Eltra infrared carbon sulfur analyzer G4 ICARUS HF/CS-i was used, the sample was burned in a high-temperature oxygen rich state, and the carbon elements contained in it were oxidized to carbon dioxide, which entered the infrared detector with the carrier gas. The mass content of carbon elements was calculated quantitatively by analyzing the changes in the infrared absorption wavelength intensity of the carbon dioxide signal.

(2) Test Method for Mass Content of Active Material in Anode Material

A sample was dried overnight and placed in a corundum crucible. The crucible was placed in a 1200°C muffle furnace (Nanyang Xinyu SA2-9-17TP) for 480 minutes to complete the combustion of carbon and the oxidation reaction of silicon or silicon monoxide to silica; during the process, the weight of the crucible m0, the weight of the sample m1, the total weight of the crucible and product after burning m2 were recorded, and the silicon content according to following formula was calculated: $Si\% = (m2 - m0)/ m1 \times 28.09/ 60.09 \times 100\%$.

(3) Test method for the mass content of oxygen element in the anode material

German Friedel Crafts Oxygen Nitrogen Hydrogen Analyzer ONH 2000 was used, the principle is that the sample is wrapped in a fluxing agent and melted in an inert atmosphere, and the oxygen elements contained in it are reduced to carbon dioxide by carbon in a graphite crucible. The generated carbon dioxide entered the infrared detector with the carrier gas, and the change in the infrared signal of carbon dioxide was quantitatively counted to calculate the mass content of oxygen elements.

(4) Test Method for Particle size of Anode Material

Malvern laser particle size analyzer MS3000 was used, based on the principle that the scattered light intensity distribution generated by particles in various directions depends on the size of the particles, large particles have small scattering angles, and small particles have large scattering angles. Therefore, the particle size distribution may be obtained by using the scattered light intensity distribution of laser diffraction.

(5) Infrared Spectrum Test Method for Anode Materials

Thermo Scientific iN10 Fourier transform infrared spectrometer from the United States was used to test a small amount of test samples and KBr tablets to obtain their infrared absorption spectra.

(6) Test Method for the Average Pore Size

Physical and Chemical Union iPore620 pore size tester and BET pore size distribution testing method were used, the isothermal adsorption characteristic curve of nitrogen gas was used to obtain the pore size distribution data of the materials through DFT simulation analysis, and then the average pore size, total pore volume, and BET specific surface area of the materials were obtained.

(7) Electrochemical Performance Test

The anode materials prepared in Examples 1 to 6 and Comparative Examples 1 to 8, conductive carbon black (super P), and LA133 were mixed in a ratio of 70: 15: 15 into a slurry and evenly coat it onto copper foil, then dried, and the anode sheet was prepared. The metal lithium sheets were used as counter electrodes and assembled into a button cell in an argon-filled glove box, and tested for charging capacity and Coulombic efficiency on a Blue Power Battery Test Cabinet M340A.
The above test data are detailed in Table 1 and Table 2.

Table 1

| | P | Total pore volume (cm³/g) | Average pore size (nm) | Specific surface area (m²/g) | Mass content of carbon (%) | Mass content of active material (%) | Mass content of oxygen element (%) | Micro-pore volume ratio (%) | Meso-pore volume ratio (%) | Macro-pore volume ratio (%) |
|---|---|---|---|---|---|---|---|---|---|---|
| | The performance parameters of the anode materials prepared in each example and comparative example |
| Example 1 | 0.6563 | 0.1892 | 1.70 | 258.7 | 50.3 | 46.2 | 3.5 | 62 | 35 | 3 |
| Example 2 | 0.4182 | 0.1253 | 3.06 | 124.6 | 50.2 | 47.2 | 2.6 | 51 | 45 | 4 |
| Example 3 | 0.3425 | 0.0426 | 5.04 | 32.7 | 49.7 | 48.5 | 1.8 | 45 | 54 | 1 |
| Example 4 | 0.2966 | 0.0014 | 9.68 | 8.6 | 49.6 | 49.3 | 1.1 | 32 | 66 | 2 |
| Example 5 | 0.6892 | 0.1943 | 1.68 | 289.2 | 51.0 | 45.0 | 4.0 | 68 | 29 | 3 |
| Example 6 | 0.6632 | 0.1902 | 1.69 | 264.4 | 50.6 | 45.5 | 3.9 | 64 | 34 | 2 |
| Comparative Example 1 | 0.1712 | 0.0412 | 2.86 | 130.7 | 52.9 | 42.8 | 4.3 | 22 | 28 | 50 |
| Comparative Example 2 | 0.1201 | 0.0263 | 5.88 | 42.4 | 53.7 | 41.1 | 5.2 | 16 | 22 | 62 |
| Comparative Example 3 | 0.0383 | 0.0086 | 7.46 | 5.6 | 54.9 | 38.8 | 6.3 | 9 | 15 | 76 |
| Comparative Example 4 | 0.0345 | 0.7903 | 7.12 | 1354.7 | 95.8 | 0.3 | 3.9 | 34 | 65 | 1 |
| Comparative Example 5 | 0.1484 | 0.1323 | 2.36 | 127.6 | 54.6 | 44.4 | 1.0 | 40 | 28 | 32 |
| Comparative Example 6 | 0.1326 | 0.0804 | 5.26 | 47.4 | 55.2 | 43.9 | 0.9 | 35 | 26 | 39 |
| Comparative Example 7 | 0.1321 | 0.0230 | 6.46 | 12.4 | 55.9 | 43.2 | 0.9 | 28 | 25 | 47 |

(continued)

| | P | Total pore volume (cm³/g) | Averag e pore size (nm) | Specific surface area (m²/g) | Mass conten t of carbon (%) | Mass conten t of active materi al (%) | Mass content of oxygen element (%) | Micro-pore volum e ratio (%) | Meso-pore volum e ratio (%) | Macro-pore volum e ratio (%) |
|---|---|---|---|---|---|---|---|---|---|---|
| | | | | The performance parameters of the anode materials prepared in each example and comparative example | | | | | | |
| Comp arative Examp le 8 | 0.1279 | 0.0124 | 8.84 | 9.0 | 56.7 | 42.5 | 0.8 | 10 | 17 | 73 |

Table 2

| The electrochemical performance parameters of the anode materials prepared in each example and comparative example | | |
|---|---|---|
| | Initial Coulomb efficiency% | Charge Capacity mAh/g |
| Example 1 | 92.8 | 1942 |
| Example 2 | 93.2 | 2083 |
| Example 3 | 92.4 | 2276 |
| Example 4 | 91.4 | 2330 |
| Example 5 | 91.7 | 1703 |
| Example 6 | 92.1 | 1804 |
| Comparative Example 1 | 87.6 | 1854 |
| Comparative Example 2 | 86.9 | 1854 |
| Comparative Example 3 | 86.2 | 1782 |
| Comparative Example 4 | 40.3 | 342 |
| Comparative Example 5 | 87.7 | 1872 |
| Comparative Example 6 | 87.1 | 1812 |
| Comparative Example 7 | 86.4 | 1789 |
| Comparative Example 8 | 85.2 | 1753 |

According to the test data in Tables 1 and 2, it may be seen that the anode materials prepared in Examples 1 to 6 include a carbon substrate and an active material. The carbon substrate has pores, and the active material is distributed within the pores of the carbon substrate, allowing the anode material to maintain a high capacity; the carbon substrate may provide a certain volume space for the expansion of the active material, which is conducive to maintaining the structural stability of the anode material. The carbon substrate may also provide electron and ion transport pathways, improve lithium ion transport efficiency, and thus improving the initial Coulomb efficiency of the anode material. Meanwhile, the pores of the carbon substrate contain $CO_2$, which may quickly dissolve in the electrolyte and promote the electrolyte to enter the pores of the anode material. Meanwhile, during the lithium intercalation process, the dissolved $CO_2$ may reduce the decomposition rate of fluoroethylene carbonate (FEC), reduce the formation of loose and irregular solid electrolyte interphases (SEI), increase the bonding effect between fluorine in the lithium fluoride SEI and lithium in the lithium silicon alloy, improve the interface stability of the lithium fluoride SEI, reduce the occurrence of side reactions, reduce the consumption of active lithium ions, and thus improving the capacity and initial Coulomb efficiency of the anode material.

FIG. 2 shows the infrared spectrogram of the anode materials prepared in Examples 1 to 4. As shown in FIG. 2 and Table 1, as the mass content of nano-silicon gradually increases in the anode materials of Examples 1 to 4, the carbon dioxide adsorption index P value of the anode materials decreases, and the adsorption amount of carbon dioxide in the anode materials decreases. This is because in the preparation process of anode materials, nano-silicon will preferentially occupy micro-pores. As the mass content of nano-silicon increases, the micro-pores in the anode materials are filled, and the proportion of micro-pores in the anode materials decreases, while the proportion of meso-pores and macro-pores increases, resulting in an increase in the average pore size of the anode materials. As the mass content of filled nano-silicon increases, the total pore volume, BET specific surface area, and oxygen content of the anode material gradually decrease. The selective adsorption of carbon dioxide is often related to the size of pore size and functional groups on the pore surface. Small pore size and functional groups that may form hydrogen bonds with carbon dioxide are often beneficial to the adsorption of carbon dioxide. As the silicon content increases, the pore size of the anode material increases, and the functional groups containing oxygen such as - OH groups on the pore surface are obscured, resulting in a weakened ability of the anode material to adsorb carbon dioxide. The infrared absorption peak at 2375cm-1 of carbon dioxide on the anode material also weakens (from a double peak to a single peak, or even disappears), and the calculated carbon dioxide adsorption index P gradually decreases.

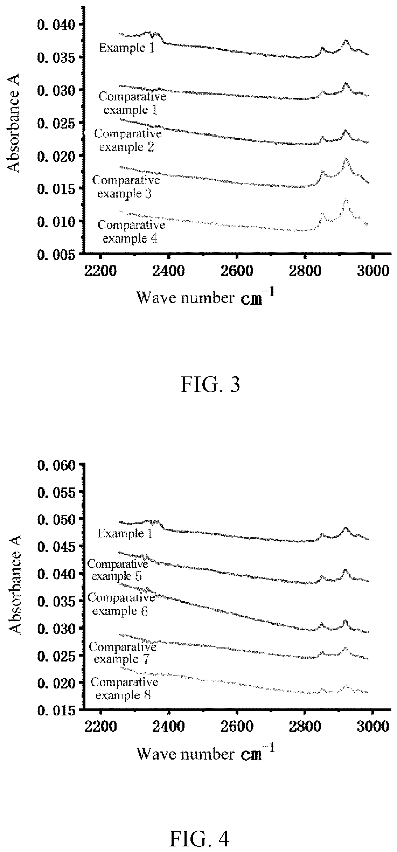

FIG. 3 is an infrared spectrogram of the anode materials prepared in Example 1 and Comparative Examples 1 to 4, as shown in FIG. 3 and Table 1, in Comparative Examples 1 to 3, with the increase of plugging-pore fluoropolymers, due to the larger surface energy of micro-pores, they will be preferentially blocked, resulting in an increase in average pore size and a decrease in total pore volume. This leads to a significant decrease in the carbon dioxide adsorption index P. Although plugging-pore fluoropolymers may introduce more functional groups containing oxygen, the excessive reduction in total pore volume leaves no room for carbon dioxide adsorption, resulting in a decrease in the amount of carbon dioxide adsorption in the anode material. Comparative Example 4 is silicon-free porous carbon, which has a large total pore volume and a high oxygen content, but its adsorption to carbon dioxide is very small, because its pore size is too large, the selective adsorption capacity to carbon dioxide is lost, and the functional group containing oxygen generated by the high oxygen content may be competitively adsorbed by water molecules and the like without pore size limitation, thereby losing its carbon dioxide adsorption capacity.

FIG. 4 shows an infrared spectrogram of the anode materials prepared in Example 1 and Comparative Examples 5 to 8. As shown in FIG. 4 and Table 1, with the increase of carbon deposition coating, the micro-pores in the anode material are occupied by carbon deposition, resulting in an increase in average pore size and a gradual decrease in total pore volume. Meanwhile, porous silicon carbon is reduced by carbon sources, and the oxygen on the silicon carbon is converted into carbon monoxide or carbon dioxide, which is lost with the airflow or covered by deposited carbon, resulting in a significant decrease in the functional groups containing oxygen on the pore surface. The increase in pore size, the decrease in total pore volume and oxygen content together result in a decrease in the carbon dioxide adsorption capacity of the anode material, leading to a reduction in the adsorption amount of carbon dioxide in the anode material and a weakening of the electrolyte adsorption capacity of the pores in the anode material. Meanwhile, during the lithium intercalation process, due to the decrease in dissolved $CO_2$, the decomposition rate of fluoroethylene carbonate (FEC) decreases, leading to an increase in the formation of a loose and irregular SEI. The bonding effect between fluorine and lithium in the lithium silicon alloy in the lithium fluoride SEI weakens, the interface stability of the lithium fluoride SEI decreases, the occurrence of secondary reactions increases, and the consumption of active lithium ions increases, resulting in a decrease in the capacity and initial Coulomb efficiency of the anode material.

The above are only preferred Examples of the present disclosure and are not intended to limit the present disclosure, and it should be noted herein that any modifications, equivalent substitutions, improvements, and the like made within the spirit and principle of the present disclosure shall fall within the protection scope of the present disclosure.

## Claims

1.  An anode material, comprising a carbon substrate and an active material, wherein the carbon substrate has pores, and at least a part of the active material is distributed within the pores of the carbon substrate;

    in an infrared spectrum of the anode material, there are a first absorption peak located at $2375\pm1cm^{-1}$ denoted as $A_1$, and a first valley located at $2394\pm1cm^{-1}$ denoted as $A_0$; and a second absorption peak located at $2919\pm1cm^{-1}$ denoted as B1, and a second valley located at $2821\pm1cm^{-1}$ denoted as $B_0$;
    the anode material has a carbon dioxide adsorption index P, wherein
    $P = (A_1 - A_0)/(B_1 - B_0)$, and $0.25 \leq P \leq 0.70$.

2.  The anode material according to claim 1, wherein the anode material satisfies at least one of following features:

    (1) the carbon substrate comprises porous carbon; and
    (2) the carbon substrate has an average particle size ranging from 8 $\mu$m to 15 $\mu$m.

3.  The anode material according to claim 1, wherein the anode material satisfies at least one of following features:

(1) the active material comprises nano-silicon; and
(2) the active material comprises nano-silicon, and the nano-silicon comprises crystalline silicon and/or amorphous silicon.

4. The anode material according to claim 1, wherein the anode material satisfies at least one of following features:

    (1) a mass content of carbon element in the anode material ranges from 49% to 51%; and
    (2) the anode material contains oxygen element, and a mass content of the oxygen element in the anode material ranges from 1.0% to 4.0%.

5. The anode material according to claim 3, wherein a mass content of silicon material in the anode material ranges from 45% to 50%.

6. The anode material according to claim 1, wherein the anode material has an average particle size ranging from 0.8 $\mu$m to 25 $\mu$m.

7. The anode material according to claim 1, wherein the anode material has a specific surface area ranging from 1 m$^2$/g to 300 m$^2$/g.

8. The anode material according to claim 1, wherein a total pore volume of the anode material ranges from 0.001 cm$^3$/g to 0.20 cm$^3$/g.

9. The anode material according to claim 1, wherein the anode material has pores, and the pores in the anode material comprise micro-pores.

10. The anode material according to claim 9, wherein the pores in the anode material further comprise at least one of meso-pores and macro-pores.

11. The anode material according to claim 9 or 10, wherein the pores in the anode material have an average pore size ranging from 1 nm to 10 nm.

12. The anode material according to claim 9, wherein a pore volume of the micro-pore has a volume proportion of 30% to 65% of a total pore volume of all pores.

13. The anode material according to claim 10, wherein the pores in the anode material further comprise meso-pores, and a pore volume of the meso-pore has a volume proportion of 35% to 70% of a total pore volume of all pores.

14. The anode material according to claim 10, wherein the anode material has pores, the pores in the anode material comprise macro-pores, and a pore volume of the macro-pore has a volume proportion of 0% to 5% of a total pore volume of all pores.

15. A lithium ion battery, comprising the anode material according to any one of claims 1 to 14.

FIG. 1

FIG. 2

FIG. 3

FIG. 4

## INTERNATIONAL SEARCH REPORT

| | International application No. |
|---|---|
| | **PCT/CN2024/102003** |

| **A.** | **CLASSIFICATION OF SUBJECT MATTER** |
|---|---|

H01M 4/583(2010.01)i; H01M4/133(2010.01)i; H01M4/38(2006.01)i; C04B35/528(2006.01)i

According to International Patent Classification (IPC) or to both national classification and IPC

| **B.** | **FIELDS SEARCHED** |
|---|---|

Minimum documentation searched (classification system followed by classification symbols)

IPC/CPC: H01M4/-; C04B35/-

Documentation searched other than minimum documentation to the extent that such documents are included in the fields searched

Electronic data base consulted during the international search (name of data base and, where practicable, search terms used)

CJFD, CNTXT, ENTXTC, WPABS: 二氧化碳, 吸附, 吸收, 活性, 孔, 隙, 碳, 电池, 电极, 负极, 阳极, co2, porous, pore, carbon, electrode, battery, negative

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| A | US 2002039686 A1 (KUREHA CHEMICAL INDUSTRY CO., LTD.) 04 April 2002 (2002-04-04)<br>description, paragraphs [0008], [0031], and [0053] | 1-15 |
| A | WO 2021241749 A1 (SHOWA DENKO K.K.) 02 December 2021 (2021-12-02)<br>description, paragraphs [0008]-[0009] and [0047] | 1-15 |
| A | US 2020373564 A1 (HITACHI CHEMICAL CO., LTD.) 26 November 2020 (2020-11-26)<br>entire document | 1-15 |
| A | CN 116111078 A (BTR NEW MATERIAL GROUP CO., LTD.) 12 May 2023 (2023-05-12)<br>entire document | 1-15 |
| A | WO 9844580 A1 (SONY CORP. et al.) 08 October 1998 (1998-10-08)<br>entire document | 1-15 |

☐ Further documents are listed in the continuation of Box C.　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **09 August 2024** | **02 September 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
**Information on patent family members**

International application No.

**PCT/CN2024/102003**

| Patent document cited in search report | | | Publication date (day/month/year) | Patent family member(s) | | | Publication date (day/month/year) |
|---|---|---|---|---|---|---|---|
| US | 2002039686 | A1 | 04 April 2002 | DE | 69809887 | D1 | 16 January 2003 |
| | | | | DE | 69809887 | T2 | 28 August 2003 |
| | | | | CA | 2280622 | A1 | 13 August 1998 |
| | | | | CA | 2280622 | C | 23 December 2003 |
| | | | | WO | 9835396 | A1 | 13 August 1998 |
| | | | | US | 6569570 | B2 | 27 May 2003 |
| | | | | JPH | 10223226 | A | 21 August 1998 |
| | | | | JP | 4104187 | B2 | 18 June 2008 |
| | | | | EP | 0958626 | A1 | 24 November 1999 |
| | | | | EP | 0958626 | B1 | 04 December 2002 |
| WO | 2021241749 | A1 | 02 December 2021 | JP | 2021187733 | A | 13 December 2021 |
| US | 2020373564 | A1 | 26 November 2020 | TW | 201935741 | A | 01 September 2019 |
| | | | | US | 11063255 | B2 | 13 July 2021 |
| | | | | EP | 3748741 | A1 | 09 December 2020 |
| | | | | EP | 3748741 | A4 | 01 September 2021 |
| | | | | KR | 20200110754 | A | 25 September 2020 |
| | | | | WO | 2019150511 | A1 | 08 August 2019 |
| | | | | JP | 6451915 | B1 | 16 January 2019 |
| | | | | JPWO | 2019150511 | A1 | 06 February 2020 |
| CN | 116111078 | A | 12 May 2023 | None | | | |
| WO | 9844580 | A1 | 08 October 1998 | TW | 458943 | B | 11 October 2001 |
| | | | | JPH | 10284089 | A | 23 October 1998 |
| | | | | JP | 4187804 | B2 | 26 November 2008 |
| | | | | CA | 2285275 | A1 | 08 October 1998 |
| | | | | CA | 2285275 | C | 16 December 2003 |
| | | | | KR | 20010005985 | A | 15 January 2001 |
| | | | | KR | 100317697 | B1 | 22 December 2001 |
| | | | | EP | 0972313 | A1 | 19 January 2000 |
| | | | | US | 6335122 | B1 | 01 January 2002 |

Form PCT/ISA/210 (patent family annex) (July 2022)

**REFERENCES CITED IN THE DESCRIPTION**

**Patent documents cited in the description**

- CN 202311407790